# EUROPEAN PATENT APPLICATION

(11) **EP 4 815 251 A1**
(43) Date of publication of application: **30.09.2026**
(21) Application number: 25837598.9
(22) Date of filing: 02.07.2025
(51) Int. Cl.: H02J 7/00, H01M 10/44, H01M 10/48, G01R 31/382, G01R 31/396

(54) **BATTERY PROTECTION APPARATUS AND BATTERY PROTECTION METHOD**

(30) Priority: 12.07.2024 KR 20240092337
(71) Applicant: LG Energy Solution, Ltd., Seoul 07335 (KR)
(72) Inventor: LEE, Jong-Min, Daejeon 34122 (KR); KWAK, Won-Suk, Daejeon 34122 (KR); KIM, Soo-Youl, Daejeon 34122 (KR); CHANG, Hyuk-Kyun, Daejeon 34122 (KR)
(74) Representative: BCKIP Part mbB
(86) International application number: PCT/KR2025/009434
(87) International publication number: WO 2026/014798

(57) **Abstract**

A battery protection apparatus according to the present disclosure includes a battery sensing unit configured to generate state data representing a measurement value of at least one state parameter of each of a plurality of battery strings of a battery assembly; a battery discharging unit connected to the plurality of battery strings and configured to perform individual energy consumption operations for the plurality of battery strings; and a controller configured to collect the state data from the battery sensing unit and, when it is determined based on the state data that a thermal propagation risk of the battery assembly exists, execute a safety operation that controls the battery discharging unit so that energy of at least one battery string among the plurality of battery strings is consumed.

## Description

### TECHNICAL FIELD

The present disclosure relates to a technology for protecting a battery assembly including a plurality of battery strings from a thermal propagation risk.

This application is based on and claims priority from Korean Patent Application No. 10-2024-0092337, filed on July 12, 2024, with the Korean Intellectual Property Office, the disclosure of which is incorporated herein in its entirety by reference.

### BACKGROUND ART

Recently, as the demand for portable electronic products such as laptops, video cameras, and mobile phones has increased rapidly and the development of electric vehicles, energy storage batteries, robots, and satellites has begun in earnest, research on high-performance batteries capable of repeated charging and discharging is actively being conducted.

Currently commercialized batteries include nickel-cadmium batteries, nickel-hydrogen batteries, nickel-zinc batteries, and lithium batteries. Among these, lithium batteries are receiving attention for their advantages of being able to charge and discharge freely, having a very low self-discharge rate, and having high energy density, as they have almost no memory effect compared to nickel-based batteries.

In a battery assembly for a battery system (e.g., electric vehicles or energy storage systems) requiring large capacity and high voltage, several to hundreds of battery strings are connected in series, parallel, or a series-to-parallel combination.

However, although the structure in which battery strings are arranged as closely as possible within the limited space of the battery system is advantageous in realizing high energy density, it has the disadvantage that risk factors of some of the battery strings may easily have a negative effect on the remaining battery strings. For example, if a thermal abnormality such as overheating, internal short circuit, or thermal runaway occurs in a small number of battery strings, the thermal abnormality may quickly spread to other adjacent battery strings, which is called 'thermal propagation'.

### DISCLOSURE

### Technical Problem

Conventionally, it is common to place a thermal blocking member between adjacent battery strings for the purpose of delaying or stopping the thermal propagation phenomenon. Thermal blocking member has high fire resistance and insulation performance, and are effective in delaying or stopping thermal propagation when the number of battery strings with thermal abnormalities is small. However, if thermal abnormalities occur simultaneously in multiple battery strings or if the thermal abnormalities in a small number of battery strings are very severe, thermal blocking members alone may not be enough to protect the battery assembly from thermal propagation.

The present disclosure is designed to solve the above problems, and aims to provide an apparatus and method for protecting a battery assembly from a thermal propagation risk by performing a forced discharge that consumes the energy of each battery string that is strongly related to the thermal propagation risk when it is determined that a thermal propagation risk of the battery assembly exists.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery protection apparatus according to an aspect of the present disclosure may comprise a battery sensing unit configured to generate state data representing a measurement value of at least one state parameter of each of a plurality of battery strings of a battery assembly; a battery discharging unit connected to the plurality of battery strings and configured to perform individual energy consumption operations for the plurality of battery strings; and a controller configured to collect the state data from the battery sensing unit and, when it is determined based on the state data that a thermal propagation risk of the battery assembly exists, execute a safety operation that controls the battery discharging unit so that energy of at least one battery string among the plurality of battery strings is consumed.

The battery discharging unit may include a plurality of switches and a discharge load. One end of the plurality of switches may be individually connected to a first terminal of the plurality of battery strings. The other end of the plurality of switches may be individually connected to one end of the discharge load. The other end of the discharge load may be individually connected to a second terminal of the plurality of battery strings.

The battery discharging unit may include a plurality of series discharge circuits individually connected in parallel to the plurality of battery strings. Each series discharge circuit may include a switch and a discharge load.

The controller may be configured to classify each of the plurality of battery strings as a normal battery string or an abnormal battery string based on the state data of each of the plurality of battery strings.

The controller may be configured to determine that a thermal propagation risk of the battery assembly exists when a predetermined number or more of the plurality of battery strings are classified as the abnormal battery string.

The controller may be configured to control the battery discharging unit so that energy of each abnormal battery string is consumed.

The controller may be configured to set at least one battery string among the plurality of battery strings as a discharge target based on a thermal abnormality index of at least one battery string among the plurality of battery strings, when it is determined that a thermal propagation risk of the battery assembly exists. The controller may be configured to control the battery discharging unit so that energy of each discharge target is consumed.

The controller may be configured to set at least one normal battery string adjacent to each abnormal battery string having a thermal abnormality index exceeding a threshold value among the plurality of battery strings as the discharge target.

The controller may be configured to identify a region of interest of each abnormal battery string based on the thermal abnormality index of each abnormal battery string among the plurality of battery strings. The controller may be configured to set each normal battery string located in the region of interest as the discharge target.

The controller may be configured to determine an energy consumption rate for each discharge target based on the thermal abnormality index of each discharge target.

A battery system according to another aspect of the present disclosure may comprise the battery protection apparatus.

A battery protection method according to still another aspect of the present disclosure may comprise: collecting state data representing a measurement value of at least one state parameter of each of a plurality of battery strings of a battery assembly; determining whether a thermal propagation risk of the battery assembly exists based on the state data; and executing a safety operation that controls a battery discharging unit connected to the plurality of battery strings so that energy of at least one battery string among the plurality of battery strings is consumed, when it is determined that a thermal propagation risk of the battery assembly exists.

The step of determining whether a thermal propagation risk of the battery assembly exists may include: classifying each of the plurality of battery strings as a normal battery string or an abnormal battery string based on the state data of each of the plurality of battery strings; and determining that a thermal propagation risk of the battery assembly exists when a predetermined number or more of the plurality of battery strings are classified as the abnormal battery string.

The step of executing a safety operation may include: setting at least one battery string among the plurality of battery strings as a discharge target based on a thermal abnormality index of at least one battery string among the plurality of battery strings, when it is determined that a thermal propagation risk of the battery assembly exists, and controlling the battery discharging unit so that energy of each discharge target is consumed.

The step of setting at least one battery string among the plurality of battery strings as a discharge target may include: setting at least one normal battery string adjacent to each abnormal battery string having a thermal abnormality index exceeding a threshold value among the plurality of battery strings as the discharge target.

The step of executing a safety operation may include: determining an energy consumption rate for each discharge target based on the thermal abnormality index of each discharge target.

### Advantageous Effects

According to at least one of the embodiments of the present disclosure, when it is determined that a thermal propagation risk of a battery assembly exists, each battery string having a strong correlation with the thermal propagation risk is set as a discharge target, and a forced discharge that consumes the energy of each discharge target is performed, thereby protecting the battery assembly from the thermal propagation risk.

In addition, according to at least one of the embodiments of the present disclosure, by setting at least one normal battery string adjacent to an abnormal battery string as a discharge target, the battery assembly may be effectively protected from the thermal propagation risk.

In addition, according to at least one of the embodiments of the present disclosure, as the thermal abnormality index of each abnormal battery string is higher, more normal battery strings are set as discharge targets, thereby effectively protecting the battery assembly from the thermal propagation risk.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a schematic diagram illustrating the configuration of a battery system according to an embodiment of the present disclosure.
FIG. 2 is a diagram used for reference to explain an example of the coupling relationship between the battery string and the battery sensing unit 210 illustrated in FIG. 1.
FIG. 3 is a diagram used for reference to explain an example of the coupling relationship between the battery assembly and the battery discharging unit illustrated in FIG. 1.
FIG. 4 is a diagram used for reference to explain another example of the coupling relationship between the battery assembly and the battery discharging unit illustrated in FIG. 1.
FIG. 5 is a flowchart used for reference to schematically explain a battery protection method according to another embodiment of the present disclosure.
FIG. 6 is a flowchart used for reference to schematically explain an example of a routine set included in step S520 of FIG. 5.
FIG. 7 is a flowchart used for reference to schematically explain another example of a routine set included in step S520 of FIG. 5.
FIG. 8 is a flowchart used for reference to schematically explain an example of a routine set included in step S530 of FIG. 5.
FIG. 9 to FIG. 12 are drawings used for reference to schematically explain exemplary relationships between input data and output data of a discharge target identification map.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as <control unit> described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

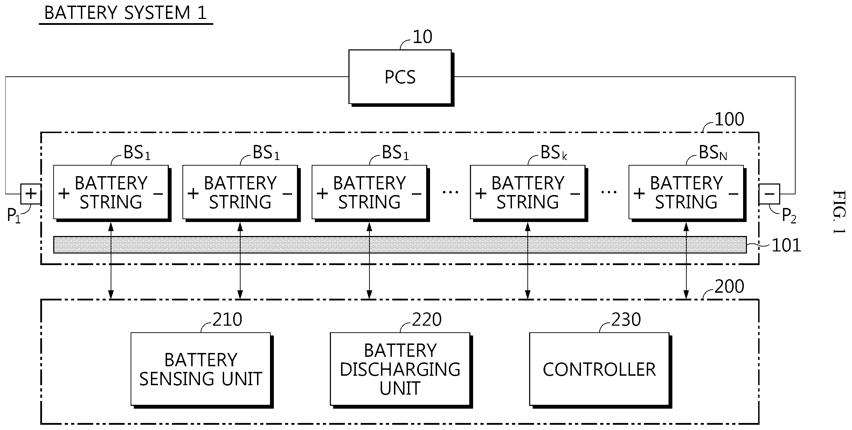

FIG. 1 is a schematic diagram illustrating the configuration of a battery system according to an embodiment of the present disclosure.

Referring to FIG. 1, the battery system 1 includes a battery assembly 100 and a battery protection apparatus 200. The battery system 1 may further include a power conversion system 10.

The battery assembly 100 includes a plurality of battery strings (BS₁ to BS_{N}, N is a natural number greater than or equal to 2), a first power terminal (P₁), and a second power terminal (P₂).

N is a natural number greater than or equal to 2. In this specification, when describing common content of the plurality of battery strings (BS₁ to BS_{N}), the symbol 'BS' or 'BSₖ' is assigned to the battery string. k is a natural number less than or equal to N. Depending on the application of the battery system 1, the battery assembly 100 may be referred to as a 'battery pack' or a 'battery rack', and the battery string BS may be referred to as a 'battery module'.

The plurality of battery strings (BS₁ to BS_{N}) may be connected in series, parallel, or a series-parallel combination between the first power terminal (P₁) and the second power terminal (P₂). The battery string BS includes at least one battery cell. When the battery string BS includes a plurality of cells, the plurality of cells may be connected in series, parallel, or a series-parallel combination. In the present specification, a battery cell refers to a basic unit of a storage element capable of independent charging and discharging, and is not particularly limited as long as it is rechargeable, such as a lithium-ion cell.

The battery assembly 100 may further include a thermal blocking member 101. The thermal blocking member 101 may be provided to at least partially cover each of the plurality of battery strings (BS₁ to BS_{N}). The thermal blocking member 101 may be a physical configuration for preventing a thermal abnormality of one battery string from causing or aggravating a thermal abnormality of another battery string by blocking direct heat transfer between adjacent battery strings.

The battery protection apparatus 200 includes a battery sensing unit 210, a battery discharging unit 220, and a controller 230.

The battery sensing unit 210 acquires state data of each of the plurality of battery strings (BS₁ to BS_{N}) of the battery assembly 100.

The battery sensing unit 210 may periodically or aperiodically measure at least one state parameter of each of the plurality of battery strings (BS₁ to BS_{N}) and transmit state data representing each measured state parameter to the controller 230. The type of the state parameter is not particularly limited as long as it can directly or indirectly represent thermal abnormality of the battery string, such as temperature, voltage, and/or shock amount.

The battery discharging unit 220 is connected to the plurality of battery strings (BS₁ to BS_{N}). The battery discharging unit 220 executes individual energy consumption operations for the plurality of battery strings (BS₁ to BS_{N}) in response to a control signal from the control unit.

In terms of hardware, the control unit 120 may be implemented using at least one of ASICs (application specific integrated circuits), DSPs (digital signal processors), DSPDs (digital signal processing devices), PLDs (programmable logic devices), FPGAs (field programmable gate arrays), microprocessors, and other electrical units to perform functions.

The controller 230 is operably coupled to the battery sensing unit 210 and the battery discharging unit 220 individually. Two components being operably coupled means that the two components are connected to transmit and receive signals in one or both directions.

The controller 230 may have a memory device. The memory device may include at least one type of storage medium among a flash memory type, a hard disk type, an SSD (Solid State Disk type), an SDD (Silicon Disk Drive type), a multimedia card micro type, a random access memory (RAM), a static random access memory (SRAM), a read-only memory (ROM), an electrically erasable programmable read-only memory (EEPROM), and a programmable read-only memory (PROM). The memory device may store data and a program required for an operation by the controller 230. The memory device may store data indicating a result of an operation by the controller 230.

The controller 230 determines whether a thermal propagation risk of the battery assembly 100 exists based on the state data received from the battery sensing unit 210. If it is determined that a thermal propagation risk of the battery assembly 100 exists, the controller 230 is configured to execute a safety operation for the battery assembly 100. The safety operation may be an operation of controlling the battery discharging unit 220 so that the energy of at least one of the plurality of battery strings (BS₁ to BS_{N}) is consumed through a forced discharge (which may also be referred to as 'energy drain').

The power conversion system 10 is electrically connected between the battery assembly 100 and a power system (not shown). The power conversion system 10 may perform bidirectional power exchange between the battery assembly 100 and the power system using a DC-AC inverter and/or a DC-DC converter provided therein. That is, the power conversion system 10 may convert AC power supplied from the power system into DC power and supply it to the battery assembly 100 while operating in a battery charging mode. The power conversion system 10 may convert DC power input by the discharge of the battery assembly 100 into AC power and supply it to the power system while operating in a battery discharging mode.

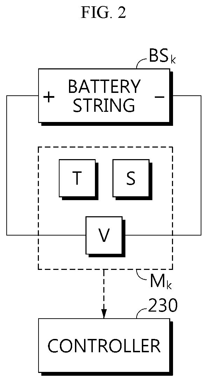

FIG. 2 is a diagram used for reference to explain an example of the coupling relationship between the battery string and the battery sensing unit 210 illustrated in FIG. 1. For convenience of explanation, only a single battery string (BSₖ) among the plurality of battery strings (BS₁ to BS_{N}) included in the battery assembly 100 is illustrated in FIG. 2.

The battery sensing unit 210 includes a plurality of battery monitoring circuits (M₁ to M_{N}) individually provided to the plurality of battery strings (BS₁ to BS_{N}), and FIG. 2 illustrates an exemplary battery monitoring circuit (Mₖ) provided to the battery string (BSₖ).

The battery monitoring circuit (Mₖ) may include at least one of a temperature sensor T, a voltage sensor V, and a shock sensor S.

The temperature sensor T is attached to the outer surface of the battery string (BSₖ) or installed at a predetermined point apart from the battery string (BSₖ) and measures the temperature of the battery string (BSₖ). The voltage sensor V is connected in parallel to the battery string (BSₖ) through the first terminal (+) and the second terminal (-) of the battery string (BSₖ) and measures the voltage of the battery string (BSₖ). The shock sensor S is attached to the outer surface of the battery string (BSₖ) or installed at a predetermined point apart from the battery string (BSₖ) and measures the amount of shock applied to the battery string (BSₖ). The battery monitoring circuit (Mₖ) may provide sensing data representing at least one measurement value among temperature, voltage, and shock amount of the battery string (BSₖ) to the controller 230.

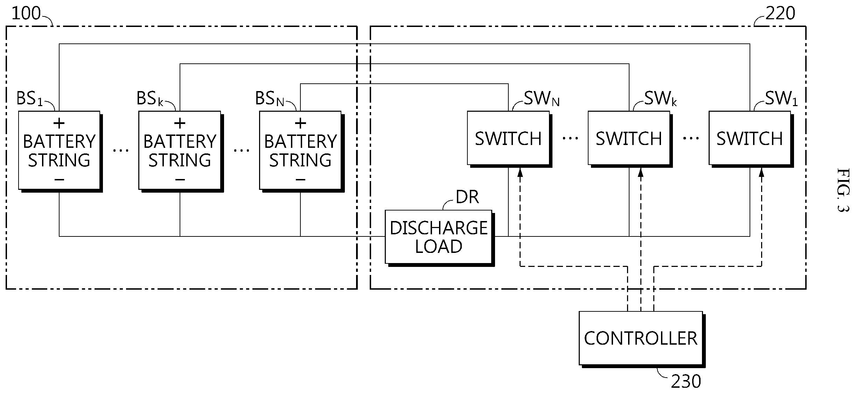

FIG. 3 is a diagram used for reference to explain an example of the coupling relationship between the battery assembly and the battery discharging unit illustrated in FIG. 1.

Referring to FIG. 3, the battery discharging unit 220 includes a plurality of switches (SW₁ to SW_{N}) and a discharge load DR.

One end of the plurality of switches (SW₁ to SW_{N}) is individually connected to the first terminal of the plurality of battery strings (BS₁ to BS_{N}). The other end of the plurality of switches (SW₁ to SW_{N}) is individually connected to one end of the discharge load DR. The other end of the discharge load DR may be individually connected to the second terminal of the plurality of battery strings (BS₁ to BS_{N}). The first terminal of the battery string (BSₖ) may be either one of the positive terminal and the negative terminal, and the second terminal of the battery string (BSₖ) may be either the other one of the positive terminal and the negative terminal.

In the coupling relationship illustrated in FIG. 3, the discharge load DR may be commonly used to consume energy of one or more of the plurality of battery strings (BS₁ to BS_{N}). The discharge load DR may be a single resistor or a combination of two or more resistors. Each resistor may be a resistive element having a fixed resistance value or an element whose resistance value can be adjusted according to an electrical signal.

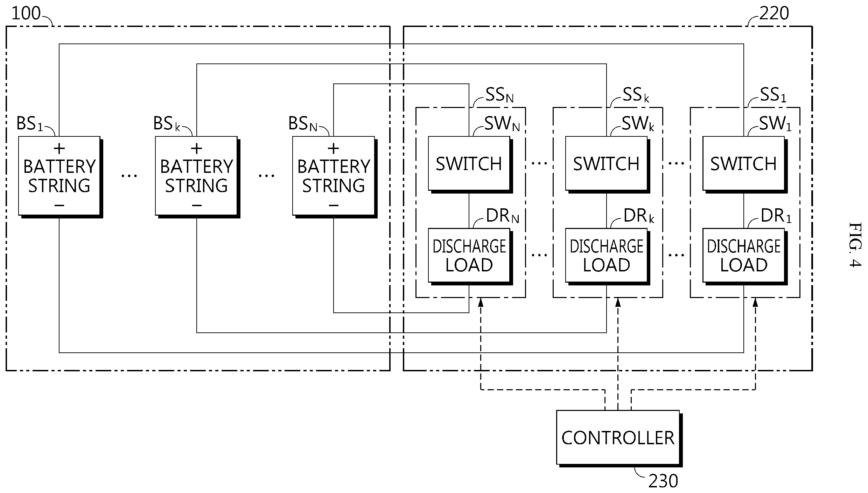

FIG. 4 is a diagram used for reference to explain another example of the coupling relationship between the battery assembly and the battery discharging unit illustrated in FIG. 1.

Referring to FIG. 4, the battery discharging unit 220 includes a plurality of series discharge circuits (SS₁ to SS_{N}).

The plurality of series discharge circuits (SS₁ to SS_{N}) are provided so that they can be individually connected in parallel to the plurality of battery strings (BS₁ to BS_{N}).

The series discharge circuit (SSₖ) includes a switch (SWₖ) and a discharge load (DRₖ). That is, the battery discharging unit 220 illustrated in FIG. 4 includes a plurality of switches (SW₁ to SW_{N}) and a plurality of discharge loads (DR₁ to DR_{N}) that are provided to be paired with each other.

The discharge load (DRₖ) of the series discharge circuit (SSₖ) is different in purpose from the discharge load DR illustrated in FIG. 3 in that the series discharge circuit (SSₖ) is solely used for consuming energy of the battery string (BSₖ) connected in parallel.

The switch (SWₖ) illustrated in FIGS. 3 and 4 may be connected to the controller 230 via a signal line. The switch (SWₖ) may be implemented by combining one or two or more of known switching devices, such as a mechanical contactor, a field effect transistor (FET), etc.

The controller 230 may apply a turn-on signal (e.g., a voltage pulse of a predetermined level or above) to the switch (SWₖ) connected to the battery string (BSₖ) set as a discharge target through a signal line. The switch (SWₖ) may be switched from a turn-off state to a turn-on state in response to the turn-on signal applied by the controller 230. In the turn-on state, as the current path between the battery string (BSₖ) and the discharge load (DR of FIG. 3 or DRₖ of FIG. 4) is conducted, energy stored in the battery string (BSₖ) is consumed by the discharge load (DR of FIG. 3 or DRₖ of FIG. 4), thereby forcibly discharging the battery string (BSₖ). The switch (SWₖ) may have a turn-off state while the turn-on signal is not applied from the controller 230.

The discharge load (DR in FIG. 3 or DRₖ in FIG. 4) may be physically separated from the plurality of battery strings (BS₁ to BS_{N}) by the thermal blocking member 101. By this structure, heat generated in the discharge load (DR in FIG. 3 or DRₖ in FIG. 4) during current conduction may be prevented from being directly applied to the plurality of battery strings (BS₁ to BS_{N}).

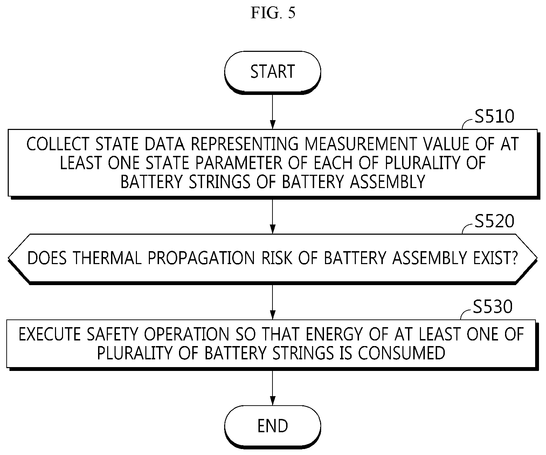

FIG. 5 is a flowchart used for reference to schematically explain a battery protection method according to another embodiment of the present disclosure. The method according to FIG. 5 may be repeatedly performed periodically or aperiodically.

Referring to FIG. 5, in step S510, the controller 230 collects state data representing the measurement value of at least one state parameter of each of the plurality of battery strings (BS₁ to BS_{N}) of the battery assembly 100 from the battery sensing unit 210.

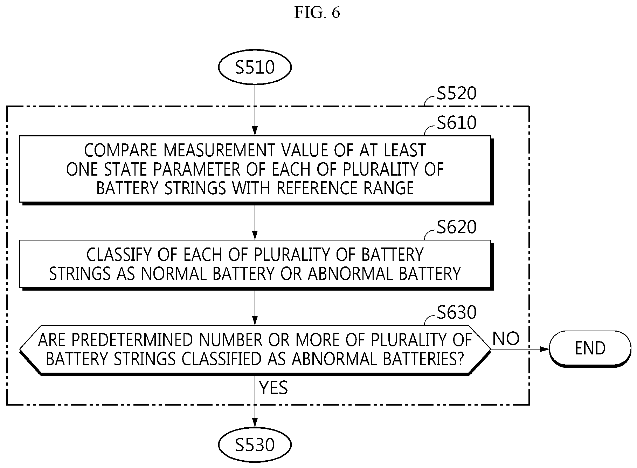

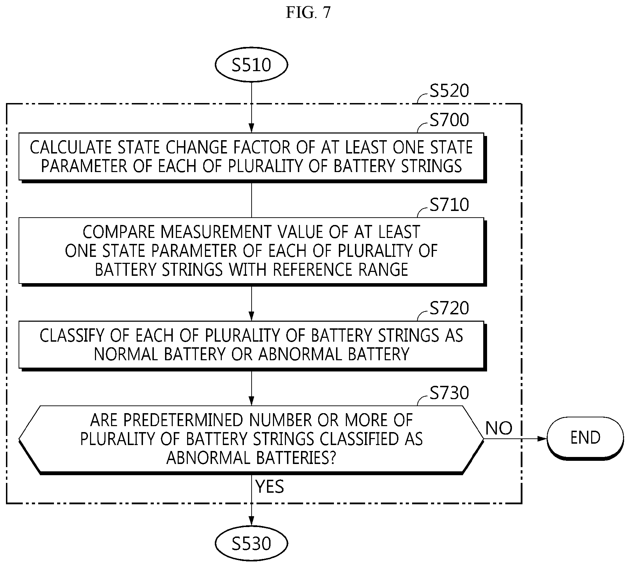

In step S520, the controller 230 determines whether a thermal propagation risk of the battery assembly 100 exists based on the state data collected in step S510. If the value of step S520 is "Yes," the method according to FIG. 5 proceeds to step S530. If the value of step S520 is "No," the method according to FIG. 5 may be terminated. A detailed description of step S520 will be provided later with reference to FIGS. 6 and 7.

In step S520, the controller 230 may calculate a thermal abnormality index of each abnormal battery string, and may further determine a thermal abnormality index of at least one normal battery string. In one embodiment, the thermal abnormality index of the battery string (BSₖ) may be determined to be identical to or directly proportional to a temperature measurement value, a temperature change factor, a voltage measurement value, a voltage change factor, a shock amount measurement value, or a shock amount change factor of the battery string (BSₖ). In another embodiment, the thermal abnormality index of the battery string (BSₖ) may be calculated by applying a predetermined mathematical operation (e.g., a weighted sum) to at least one of the temperature measurement value, the temperature change factor, the voltage measurement value, the voltage change factor, the shock amount measurement value, and the shock amount change factor of the battery string (BSₖ). For example, at least one function that outputs a value having a positive corresponding relationship to the measurement value or the state change factor of each state parameter as a thermal abnormality index may be used as the mathematical operation in step S520.

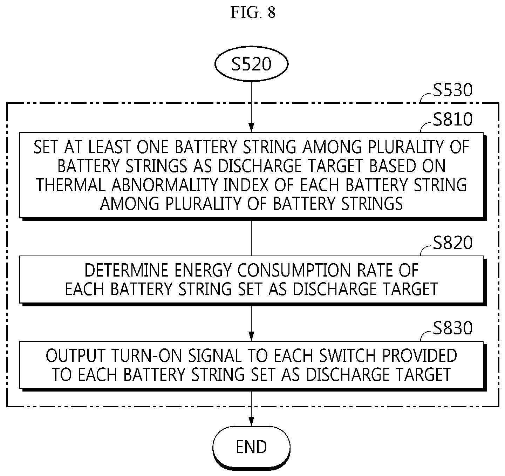

In step S530, the controller 230 executes a safety operation to control the battery discharging unit 220 connected to the plurality of battery strings (BS₁ to BS_{N}) so that energy of at least one of the plurality of battery strings (BS₁ to BS_{N}) is consumed. A detailed description of step S530 will be provided later with reference to FIGS. 8 to 12.

FIG. 6 is a flowchart used for reference to schematically explain an example of a routine set included in step S520 of FIG. 5.

Referring to FIG. 6, in step S610, the controller 230 compares the measurement value (included in the state data collected in step S510) of at least one state parameter of each of the plurality of battery strings (BS₁ to BS_{N}) with a reference range. For example, if the state parameter is 'temperature,' the reference range for it may represent a predetermined normal temperature range. If the state parameter of a certain battery string is outside the reference range, it can be said that the battery string is definitely abnormal or has a strong abnormality sign.

If a plurality of state parameters are used to determine the presence of thermal propagation risk, multiple reference ranges may also be provided. For example, if three state parameters, 'temperature', 'voltage', and 'shock amount', are used, three reference ranges may be pre-memorized in the memory.

In step S620, the controller 230 classifies each of the plurality of battery strings (BS₁ to BS_{N}) as a normal battery string or an abnormal battery string based on the comparison result in step S610. Step S620 may be performed based only on the comparison result for a single reference range, or may be performed based on the comparison result for two or more reference ranges. For example, each battery string in which the temperature measurement value is outside the reference range (for temperature) may be classified as an abnormal battery string. For another example, each battery string in which the temperature measurement value is outside the reference range (for temperature) and the voltage measurement value is also outside the reference range (for voltage) may be classified as an abnormal battery string, and the remaining battery strings may be classified as normal battery strings.

In step S620, an operation of recording identification information of each battery string associated with a measurement value within a reference range in a normal battery string list and/or an operation of recording identification information of each battery string associated with a measurement value outside the reference range in an abnormal battery string list may be performed. Each of the plurality of battery strings (BS₁ to BS_{N}) is fixedly arranged in a unique area within the battery assembly 100, and the identification information for each battery corresponds to the physical location of each battery.

In step S630, the controller 230 determines whether a predetermined number or more among the plurality of battery strings (BS₁ to BS_{N}) are classified as abnormal battery strings. The predetermined number may be 1 or more. If the value of step S630 is "Yes", it may mean that it is determined that a thermal propagation risk of the battery assembly 100 exists. For example, if the number of identification information recorded in the abnormal battery string list is greater than or equal to the predetermined number, the value of step S630 is output as "Yes".

FIG. 7 is a flowchart used for reference to schematically explain another example of a routine set included in step S520 of FIG. 5.

Referring to FIG. 7, in step S700, the controller 230 calculates a state change factor of at least one state parameter of each of the plurality of battery strings (BS₁ to BS_{N}) based on the state data of each of the plurality of battery strings (BS₁ to BS_{N}). For example, when the state parameter is 'temperature,' at least one of the 'temperature rise amount' or the 'temperature rise rate' for a predetermined period of time may be calculated as the state change factor. As another example, when the state parameter is 'voltage,' at least one of the 'voltage drop amount' or the 'voltage drop rate' for a predetermined period of time may be calculated as the state change factor.

In step S710, the controller 230 compares at least one state change factor of each of the plurality of battery strings (BS₁ to BS_{N}) with a reference range. The reference range used in step S710 may be predetermined separately from the reference range used in step S610 of FIG. 6 described above, in that it is related to the change factor.

In step S720, the controller 230 classifies each of the plurality of battery strings (BS₁ to BS_{N}) as a normal battery string or an abnormal battery string based on the comparison result in step S710.

Step S720 may be performed based only on the comparison result for a single reference range, or based on the comparison result for two or more reference ranges. For example, each battery string whose temperature rise rate is outside the reference range (for the temperature rise rate) may be classified as an abnormal battery string, and each remaining battery string may be classified as a normal battery string. For another example, each battery string whose temperature rise rate is outside the reference range (for the temperature rise rate) and whose voltage drop amount is also outside the reference range (for the voltage drop amount) may be classified as an abnormal battery string, and each remaining battery string may be classified as a normal battery string.

In step S720, an operation of recording identification information of each battery string having a state change factor within a reference range in a normal battery string list and/or an operation of recording identification information of each battery string having a state change factor outside the reference range in an abnormal battery string list may be performed.

In step S730, the controller 230 determines whether a predetermined number or more of the plurality of battery strings (BS₁ to BS_{N}) are classified as abnormal battery strings. Step S730 may be substantially the same as step S630.

FIG. 8 is a flowchart used for reference to schematically explain an example of a routine set included in step S530 of FIG. 5.

Referring to FIG. 8, in step S810, the controller 230 sets at least one battery string among the plurality of battery strings (BS₁ to BS_{N}) as a discharge target based on the thermal abnormality index of at least one battery string among the plurality of battery strings (BS₁ to BS_{N}). The discharge target setting procedure in step S810 may be performed based on the thermal abnormality index of each abnormal battery string, and may also be performed further based on the thermal abnormality index of at least one normal battery string.

In one embodiment, each abnormal battery string may be set as a discharge target, and at least one normal battery string may be set as an additional discharge target. Since an abnormal battery string exerts a thermal influence on its surrounding area, a normal battery string adjacent to the abnormal battery string may be exposed to the risk of thermal propagation. Accordingly, an adjacent normal battery string may also be set as an additional discharge target.

In another embodiment, among all abnormal battery strings, only each abnormal battery string with discharge validity may be set as a discharge target, and at least one normal battery string may be set as an additional discharge target. The discharge validity of the battery string (BSₖ) may mean a state in which the thermal abnormality index of the battery string (BSₖ) can be lowered below a certain level if a forced discharge is immediately performed. For example, in a situation in which the battery string (BSₖ) has already ignited or the signs of ignition are excessive, even if a forced discharge is immediately performed on the battery string (BSₖ), the ignition cannot be prevented, or the thermal abnormality may rather worsen due to the forced discharge, and therefore the battery string (BSₖ) may be said to have no discharge validity.

Each battery string having a thermal abnormality index less than a threshold value may be determined as a normal battery string. Conversely, each battery string having a thermal abnormality index greater than or equal to the threshold value may be determined as an abnormal battery string. An abnormal battery string having a thermal abnormality index greater than or equal to a reference value (greater than the threshold value) may be determined to have no discharge validity. The controller 230 may exclude each abnormal battery string having no discharge validity from the discharge target.

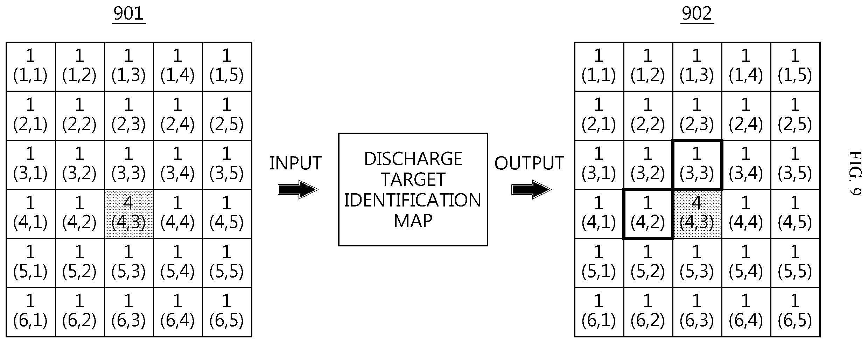

The controller 230 may set at least one normal battery string adjacent to each abnormal battery string having a thermal abnormality index exceeding a threshold value among the plurality of battery strings (BS₁ to BS_{N}) as a discharge target. Specifically, the controller 230 may identify a region of interest of each abnormal battery string based on the thermal abnormality index of each abnormal battery string. For example, in FIG. 9, which will be described later, the grids of coordinates (3,3) and (4,2) indicated by bold borders may represent a region of interest when the thermal abnormality index of the battery string corresponding to coordinate (4,3) is 4. A look-up table indicating the corresponding relationship between the thermal abnormality index of each battery string and the region of interest may be pre-recorded in a memory device. The controller 230 may set each normal battery string located in the region of interest of each abnormal battery string as a discharge target.

In step S820, the controller 230 determines an energy consumption rate for each battery string set as a discharge target. The controller 230 may determine the energy consumption rate of each battery string set as a discharge target based on a thermal abnormality index (or a corrected thermal abnormality index) of each battery string set as a discharge target. In one embodiment, the controller 230 may apply a predetermined positive corresponding relationship to the thermal abnormality index (or the corrected thermal abnormality index) of each battery string set as a discharge target to determine a duty ratio of a turn-on signal for a switch (e.g., SW₂) provided to each battery string (e.g., BS₂) set as a discharge target. Of course, the energy consumption rate for the discharge target may be predetermined, and in this case, step S820 may be omitted from the method of FIG. 8. As the duty ratio of the turn-on signal output to the switch (e.g., SW₂) increases, the turn-on period per unit time of the switch (e.g., SW₂) increases, so the energy consumption rate of the battery string (e.g., BS₂) provided with the switch (e.g., SW₂) may increase.

In step S830, the controller 230 outputs a turn-on signal to each switch provided to each battery string set as a discharge target among the plurality of switches (SW₁ to SW_{N}). Each battery string set as a discharge target is individually forcibly discharged by step S830, thereby blocking thermal propagation within the battery assembly 100, or at least significantly slowing down the speed of thermal propagation, and limiting the risk caused by thermal propagation.

The controller 230 may perform step S810 (discharge target setting procedure) of FIG. 8 by calling the discharge target identification map stored in the memory device.

The discharge target identification map may be a set of data tables, a set of functions, or a combination thereof, designed in advance to return the identification information of each battery string set as a discharge target among the plurality of battery strings (BS₁ to BS_{N}) when the thermal abnormality index of at least one battery string among the plurality of battery strings (BS₁ to BS_{N}) is input.

For example, the discharge target identification map may include a plurality of data tables prepared in advance to individually indicate a plurality of discharge target sets (each discharge target set representing a list of at least one discharge target) depending on the thermal abnormality index of each battery string. When any one data table corresponding to the data input from the discharge target identification map is output, the controller 230 may set each battery string indicated in the output data table as a discharge target.

As another example, the discharge target identification map may include a plurality of functions that are one-to-one associated with the plurality of battery strings (BS₁ to BS_{N}). The equation below is associated with the kth battery string and is an example of a function that may be included in the discharge target identification map.${F}_{k _ corrected} = {F}_{k} + f \left({F}_{1}, {F}_{2}, ⋯, {F}_{k - 1}, {F}_{k + 1}, ⋯, {F}_{N}\right) = {F}_{k} + Δ {F}_{k}$

In the above equation, when i is a natural number less than or equal to N, Fᵢ represents a thermal abnormality index of the ith battery string, F_{i_corrected} represents a corrected thermal abnormality index of the ith battery string, and ΔFᵢ represents an index correction value that reflects the thermal proximity between each battery string other than the ith battery string and the ith battery string. That is, in the above formula, function f() may be predetermined to output ΔFₖ when the thermal abnormality indices of (N-1) battery strings other than the kth battery string are input. Of course, those skilled in the art will easily understand that each thermal abnormality index of the (N-1) battery strings other than the kth battery string may have a predetermined positive corresponding relationship to ΔFₖ.

The discharge target identification map may output a result value (e.g., identification information of the kth battery string) indicating that the kth battery string is set as a discharge target when F_{k_corrected} is greater than or equal to a threshold value. On the other hand, the discharge target identification map may output a result value indicating that the kth battery string is excluded from the discharge target when F_{k_corrected} is less than the threshold value or greater than or equal to a reference value.

FIG. 9 to FIG. 12 are drawings used for reference to schematically explain exemplary relationships between input data and output data of a discharge target identification map.

In explaining FIGS. 9 to 12, for the sake of understanding, the input/output data is visualized and illustrated as having a 6×5 matrix data table, and it is assumed that 30 grids of the data table individually correspond to the physical locations of the plurality of battery strings (BS₁ to BS_{N}, assuming N = 30) within the battery assembly 100. In addition, for each grid, it is assumed that the coordinate at the bottom represents the physical location of the battery string corresponding to the grid, and the number at the top represents the thermal abnormality index of the battery string corresponding to the grid. In addition, it is assumed that the threshold value is 2 and the reference value is 6.

First, referring to FIG. 9, in the left data table representing the input data 901, only the grid corresponding to coordinate (4,3) is shaded. The shaded grid indicates that the battery string corresponding to the grid is abnormal, and this is confirmed by the fact that, unlike the remaining grids, the thermal abnormality index of the grid alone is 4, which is greater than the threshold value 2.

Looking at the right data table representing the output data 902, only the grid corresponding to coordinate (4,3) is shaded, which is common to the input data 901, but two grids corresponding to the two coordinates (4,2) and (3,3) are marked with bold borders. The grids marked with bold borders represent normal battery strings set as discharge targets. In other words, the two battery strings corresponding to the two coordinates (4,2) and (3,3) are currently in a normal state with minimal thermal abnormality, but they can be identified as having a high thermal propagation risk due to the abnormal battery string corresponding to the grid at coordinate (4,3).

When the output data 902 is output from the discharge target identification map, the controller 230 may set three battery strings corresponding to coordinates (4,3), (4,2), and (3,3) as discharge targets.

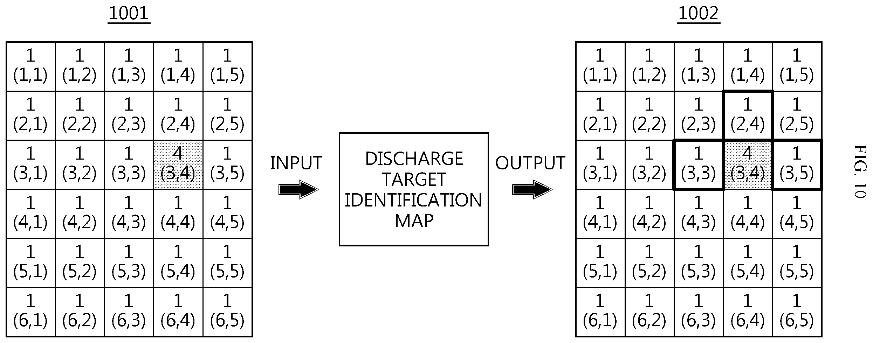

Next, referring to FIG. 10, in the left data table representing the input data 1001, only the grid corresponding to coordinate (3,4) is shaded, which is confirmed from the fact that the thermal abnormality index of coordinate (3,4) is 4.

Looking at the right data table representing the output data 1002, only the grid corresponding to coordinate (3,4) is shaded, which is common to the input data 1001, but three grids corresponding to coordinates (2,4), (3,3), and (3,5) are marked with bold borders. That is, the three battery strings corresponding to coordinates (2,4), (3,3), and (3,5) are currently in a normal state, but can be identified as having a high thermal propagation risk due to the abnormal battery string corresponding to the grid at coordinate (3,4).

When comparing FIG. 9 and FIG. 10, the two input data 901, 1001 are common in that only a single battery string with a thermal abnormality index of 4 is abnormal, but the output data 902 indicates that two normal battery strings are set as discharge targets, whereas the output data 1002 indicates that three normal battery strings are set as discharge targets. This may reflect the results of a preliminary simulation in which the influence on the surrounding area varies depending on the physical location of each abnormal battery string, even if the number of abnormal battery strings and the thermal abnormality index are the same.

When the output data 1002 is output from the discharge target identification map, the controller 230 may set four battery strings corresponding to coordinates (3,4), (2,4), (3,3), and (3,5) as discharge targets.

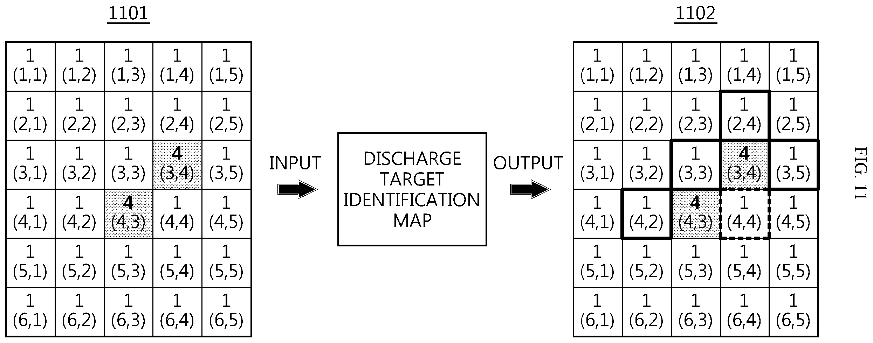

Referring to FIG. 11, in the left data table representing the input data 1101, only two grids corresponding to coordinates (4,3) and (3,4) are shaded. The shading of coordinate (4,3) is common to the input data 901 and the input data 1101, and the shading of coordinate (3,4) is common to the input data 1001 and the input data 1101.

Looking at the right data table representing the output data 1102, only two grids are shaded, which is common to the input data 1101, and four grids corresponding to coordinates (2,4), (3,3), (3,5), and (4,2) are marked with bold borders. Here, the bold borders of coordinates (3,3) and (4,2) are common to the output data 902 and the output data 1102, and the bold borders of coordinates (2,4), (3,3), and (3,5) are common to the output data 1002 and the output data 1102.

It is noteworthy that in the output data 1102, a bold border (dotted line) is displayed at coordinate (4,4), which is not displayed in bold border in the output data 902 and the output data 1002. This may reflect the results of a preliminary simulation in which the risk of ignition in the area between two or more abnormal battery strings, where the abnormal states of two or more abnormal battery strings overlap and act, is significantly increased.

When the output data 1102 is output from the discharge target identification map, the controller may can set seven battery strings corresponding to coordinates (3,4), (4,3), (2,4), (3,3), (3,5), (4,2) and (4,4) as discharge targets.

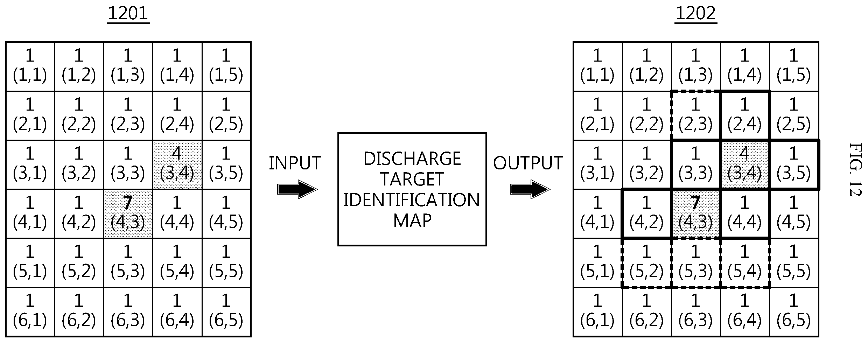

Referring to FIG. 12, in the left data table representing the input data 1201, only the two grids corresponding to coordinates (4,3) and (3,4) are shaded. The shading of coordinates (4,3) and (3,4) is common to the input data 1101 and the input data 1201. However, the input data 1201 differs from the input data 1101 in that the thermal abnormality index of coordinate (4,3) is 7 (exceeding the reference value).

Looking at the right data table representing the output data 1202, the fact that only two grids are shaded and the fact that the five grids corresponding to coordinates (2,4), (3,3), (3,5), (4,2), (4,4) are marked with a bold border are common to the output data 1102.

It is noteworthy that in the output data 1202, bold borders are displayed at coordinates (2,3), (5,2), (5,3), and (5,4), which are not displayed with bold borders in the output data 1102. In particular, a bold border is displayed at the grid of coordinate (2,3), which is separated from the grid of coordinate (4,3) by the grid of coordinate (3,3). This may reflect the results of a preliminary simulation in which as the thermal abnormality index of an abnormal battery string higher, the risk of ignition to other battery strings located in the surrounding area far away is increased.

When the output data 1202 is output from the discharge target identification map, the controller 230 may set 11 battery strings corresponding to coordinates (3,4), (4,3), (2,3), (2,4), (3,3), (3,5), (4,2), (4,4), (5,2), (5,3), and (5,4) as discharge targets. Alternatively, the controller 230 may set 10 battery strings, excluding the battery string corresponding to coordinate (4,3) having a thermal abnormality index exceeding a reference value, as discharge targets.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

## Claims

1. A battery protection apparatus, comprising:
a battery sensing unit configured to generate state data representing a measurement value of at least one state parameter of each of a plurality of battery strings of a battery assembly;
a battery discharging unit connected to the plurality of battery strings and configured to perform individual energy consumption operations for the plurality of battery strings; and
a controller configured to collect the state data from the battery sensing unit and, when it is determined based on the state data that a thermal propagation risk of the battery assembly exists, execute a safety operation that controls the battery discharging unit so that energy of at least one battery string among the plurality of battery strings is consumed.

2. The battery protection apparatus according to claim 1,
wherein the battery discharging unit includes a plurality of switches and a discharge load,
wherein one end of the plurality of switches is individually connected to a first terminal of the plurality of battery strings,
wherein the other end of the plurality of switches is individually connected to one end of the discharge load, and
wherein the other end of the discharge load is individually connected to a second terminal of the plurality of battery strings.

3. The battery protection apparatus according to claim 1,
wherein the battery discharging unit includes a plurality of series discharge circuits individually connected in parallel to the plurality of battery strings, and
wherein each series discharge circuit includes a switch and a discharge load.

4. The battery protection apparatus according to claim 1,
wherein the controller is configured to:
classify each of the plurality of battery strings as a normal battery string or an abnormal battery string based on the state data of each of the plurality of battery strings, and
determine that a thermal propagation risk of the battery assembly exists when a predetermined number or more of the plurality of battery strings are classified as the abnormal battery string.

5. The battery protection apparatus according to claim 4,
wherein the controller is configured to control the battery discharging unit so that energy of each abnormal battery string is consumed.

6. The battery protection apparatus according to claim 1,
wherein the controller is configured to:
set at least one battery string among the plurality of battery strings as a discharge target based on a thermal abnormality index of at least one battery string among the plurality of battery strings, when it is determined that a thermal propagation risk of the battery assembly exists, and
control the battery discharging unit so that energy of each discharge target is consumed.

7. The battery protection apparatus according to claim 6,
wherein the controller is configured to set at least one normal battery string adjacent to each abnormal battery string having a thermal abnormality index exceeding a threshold value among the plurality of battery strings as the discharge target.

8. The battery protection apparatus according to claim 6,
wherein the controller is configured to:
identify a region of interest of each abnormal battery string based on the thermal abnormality index of each abnormal battery string among the plurality of battery strings, and
set each normal battery string located in the region of interest as the discharge target.

9. The battery protection apparatus according to claim 6,
wherein the controller is configured to determine an energy consumption rate for each discharge target based on the thermal abnormality index of each discharge target.

10. A battery system, comprising the battery protection apparatus according to any one of claims 1 to 9.

11. A battery protection method, comprising:
collecting state data representing a measurement value of at least one state parameter of each of a plurality of battery strings of a battery assembly;
determining whether a thermal propagation risk of the battery assembly exists based on the state data; and
executing a safety operation that controls a battery discharging unit connected to the plurality of battery strings so that energy of at least one battery string among the plurality of battery strings is consumed, when it is determined that a thermal propagation risk of the battery assembly exists.

12. The battery protection method according to claim 11,
wherein the step of determining whether a thermal propagation risk of the battery assembly exists includes:
classifying each of the plurality of battery strings as a normal battery string or an abnormal battery string based on the state data of each of the plurality of battery strings; and
determining that a thermal propagation risk of the battery assembly exists when a predetermined number or more of the plurality of battery strings are classified as the abnormal battery string.

13. The battery protection method according to claim 11,
wherein the step of executing a safety operation includes:
setting at least one battery string among the plurality of battery strings as a discharge target based on a thermal abnormality index of at least one battery string among the plurality of battery strings, when it is determined that a thermal propagation risk of the battery assembly exists, and
controlling the battery discharging unit so that energy of each discharge target is consumed.

14. The battery protection method according to claim 13,
wherein the step of setting at least one battery string among the plurality of battery strings as a discharge target includes:
setting at least one normal battery string adjacent to each abnormal battery string having a thermal abnormality index exceeding a threshold value among the plurality of battery strings as the discharge target.

15. The battery protection method according to claim 13,
wherein the step of executing a safety operation includes:
determining an energy consumption rate for each discharge target based on the thermal abnormality index of each discharge target.
